# EUROPEAN PATENT SPECIFICATION

(11) **EP 4 624 943 B1**
(45) Date of publication and mention of the grant of the patent: **24.12.2025**
(21) Application number: 24166081.0
(22) Date of filing: 25.03.2024
(51) Int. Cl.: G01R 15/20

(54) **CURRENT TRANSDUCER WITH INTEGRATED CIRCUIT AND LEADFRAME CONDUCTOR ARRANGEMENT**
STROMWANDLER MIT INTEGRIERTER SCHALTUNG UND LEITERRAHMENLEITERANORDNUNG
TRANSDUCTEUR DE COURANT AVEC CIRCUIT INTÉGRÉ ET ARRANGEMENT DE CONDUCTEURS DE GRILLE DE CONNEXION

(43) Date of publication of application: 01.10.2025
(73) Proprietor: LEM International SA, 1217 Meyrin (CH)
(72) Inventor: ZIGLIOLI, Federico, 1207 Genève (CH); MESSIER, Loïc, 74270 VANZY (FR)
(74) Representative: reuteler & cie SA

(56) References cited:
- WO-A1-2019/049414
- US-A1- 2014 151 697
- US-A1- 2018 180 649
- US-A1- 2023 288 453

## Description

The present invention relates to an open loop current transducer with integrated circuit and conductor leadframe arrangement for surface mounting on a circuit board.

It is known to provide an open loop coreless current transducer with an integrated circuit and conductor leadframe arrangement in an overmold package having surface mount electrical connections for mounting on a circuit board, for instance as disclosed in US2014151697A1. Such coreless open loop current transducers have an integrated circuit (IC) chip with a magnetic field sensor detecting the magnetic field induced by a current to be measured flowing in the primary conductor, the integrated circuit chip being electrically connected to secondary contacts that supply power and allow transmission of the measurement signal to an external circuit board. Such open loop current transducers with an integrated circuit may have a differential magnetic field measurement sensor that measures a magnetic field gradient across a section of primary conductor. Such current transducers typically have an overall package dimensions of less than 20x20mm, often less than 10x10mm.

For compact open loop current transducers with an integrated circuit having a differential magnetic field measurement sensor, it has been observed that the PCB conductor layout and thickness on the external circuit board on which the current transducer is mounted affects the current transducer measurement signal. This adversely affects the measurement signal accuracy or requires calibration of the current transducer for each external PCB configuration, which is costly to perform.

In view of the foregoing, it is an object of the present invention to provide an open loop current transducer with an integrated circuit having a differential magnetic field measurement sensor for surface mounting on a circuit board, that is accurate and has reduced sensitivity to external PCB conductor layout and thickness.

It is advantageous to provide a current transducer that is compact and economical to manufacture.

Objects of the invention have been achieved by providing a current transducer according to claim 1.

Disclosed herein is a current transducer comprising a magnetic field sensor, a leadframe arrangement comprising secondary conductors and a primary conductor, and an overmold insulating housing encapsulating the magnetic field sensor and portions of the primary conductor and secondary conductors,
the primary conductor comprising a first connection end termina and a second connection end terminal separate by a slot, and a bridging branch interconnecting the first connection end terminal (10a) to the second connection end terminal, the first connection end terminal and a second connection end terminal having a thickness H1 and exposed pads for surface mount connection to conductive tracks on an external circuit board,
the bridging branch having an indent with a thickness H2 smaller than the connection end terminal thickness H1, the indent spanning across the bridging branch.

The bridging branch comprises chamfer edges formed in corners of the first and second connection terminals bounding the bridging branch, the chamfer edges extending from the slot and diverging outwardly from the slot at an angle (***β***) from a centreline (***C***).

The magnetic field sensor comprises a first sensor and a second sensor spaced apart and configured for measuring a magnetic field gradient across a width of the bridging branch.

The first sensor is positioned overhead an inner edge of the bridging branch and the second sensor is situated overhead an outer edge of the bridging branch.

In an advantageous embodiment, an average value of said angle (***β***) is in a range of 20 to 60°, preferably in a range of 20° to 50°, for instance in a range of 20° to 40°.

In an advantageous embodiment, the indent thickness H2 is less than 70% of the connection terminal thickness ***H1** (**H2**<0.7x**H1**)* preferably less than 60% (H2<0.6xH1), for instance about 50% *(H2* = 0.5xH1).

In an advantageous embodiment, the first connection end terminal and a second connection end terminal thickness ***H1*** which corresponds to leadframe arrangement thickness, is in a range of 0,3mm to 1mm, for instance in a range of 0,35mm to 0,6mm.

In an advantageous embodiment, the indent extends into the leadframe arrangement from a mounting side including the exposed pads for surface mount connection.

In an advantageous embodiment, the current transducer comprises an integrated circuit, the magnetic field sensor being included in the integrated circuit.

In an advantageous embodiment, the magnetic field sensor is connected to the secondary conductors with bond wires.

In an advantageous embodiment, the magnetic field sensor is mounted on a surface of the primary conductor separated therefrom by an insulating layer.

In an advantageous embodiment, the primary conductor comprises a shape that has mirror image symmetry about a centre line *(**C**)**.***

In an advantageous embodiment, the first connection end terminal and second connection end terminal each have a width of over 30% of a total width of the current transducer, preferably of over 40%.

In an advantageous embodiment, the width ***T1*** of each connection end terminal is in a range of 1mm to 4mm, for instance in a range of 1,5mm to 3mm.

In an advantageous embodiment, a width ***G*** of the slot is in a range of 0,3mm to 0,8mm, for instance in a range of 0,3mm to 0,6mm.

Further objects and advantageous features of the invention will be apparent from the claims, from the detailed description, and annexed drawings, in which:

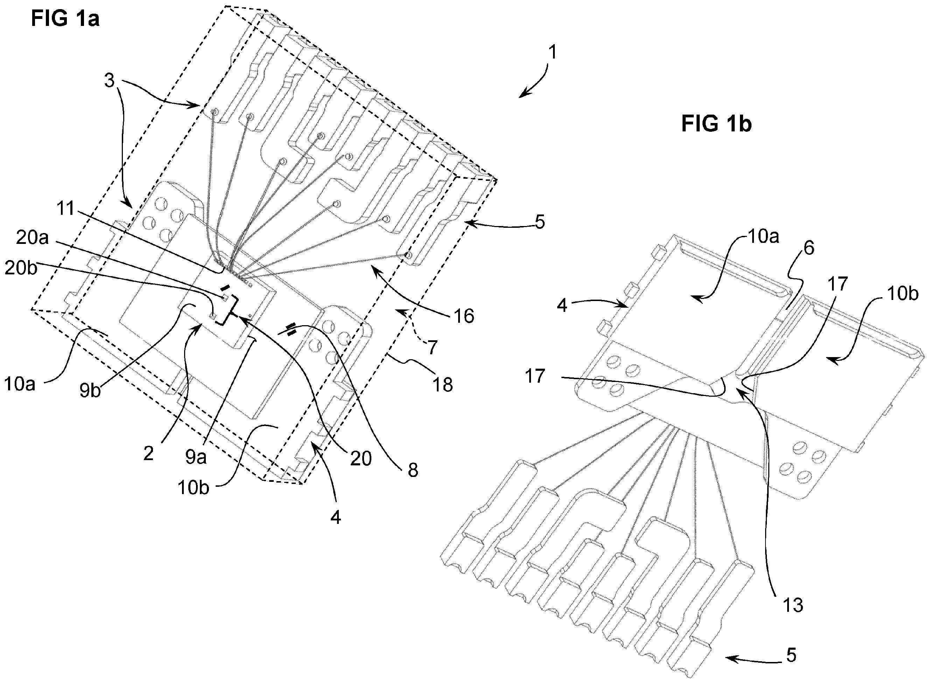

Figure 1a is a perspective view of a current transducer according to an embodiment of the invention, the overmold housing portion being shown transparent;
Figure 1b is a perspective view of the current transducer of figure 1a, seen from a mounting side, with the overmold housing removed;

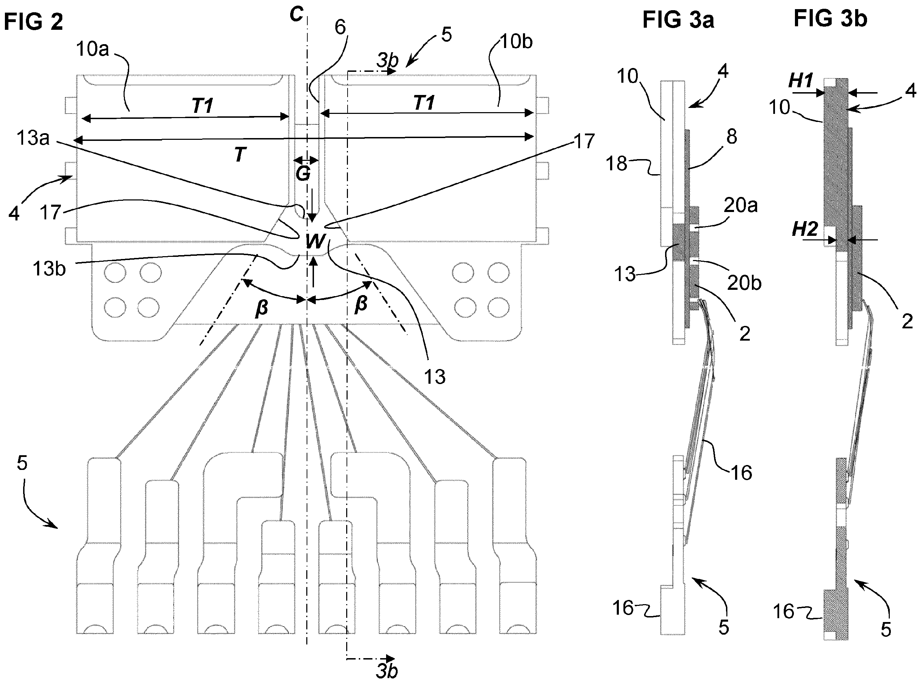

Figure 2 is a plan view of the embodiment of figure 1b;
Figure 3a is a cross-sectional view through centreline ***C*** of figure 2;
Figure 3b is a cross-sectional view through line 3b-3b of figure 2;
Figure 4a is a perspective view of a model of a current transducer similar to figures 1a and 1b mounted on an external PCB for simulation purposes;
Figure 4b is a plot of measurement sensitivity variation of the simulation model of figure 4a as a function of varying thickness of the PCB conductor tracks.

Referring to the figures, a current transducer 1 for surface mount connection on an external circuit board comprises an integrated circuit (IC) chip 2 mounted on a lead frame arrangement 3 housed within an insulating overmold housing 7.

The lead frame arrangement 3 comprises a primary conductor 4 and a plurality of secondary conductors 5, and optionally a shield conductor (not shown). The lead frame arrangement is formed from a sheet of conductive metal, more specifically in the form of a band or strip that is stamped and formed in a stamping and forming process to cut out, bend and/or emboss the sheet metal to form the primary conductor and secondary conductors. Stamping and forming of lead frame arrangements from sheet metal are *per se* well known techniques.

The integrated circuit (IC) chip 2 has a first active side 9a and a second side 9b, at least the first active side 9a having active portions including electrical connection terminals 11 for connection to power and signal transmission conductors and a magnetic field sensor 20 arranged at or close to the surface of the first active side 9a. The magnetic field sensor is configured to measure a magnetic field generated by a current to be measured flowing in the primary conductor 4.

The magnetic field sensor 20 may comprise a Hall effect sensor, or a giant magneto-resistive sensor or other forms of magnetic field sensors that are *per se* well known in the art. The IC chip 2 may for instance be in the form of a CMOS chip although other types of semi-conductor integrated circuit chips with magnetic field sensing portions *per se* known in the art may be used. The semi-conductor chip does not need to be further described, such semi-conductor chips with magnetic field sensing portions and connection terminals being *per se* well known in the art.

The secondary conductors 5 which serve to interconnect the IC chip 2 to power and signal connections of an external circuit to which the current transducer is intended to be connected, comprise a plurality of conductors formed from the lead frame arrangement, each secondary conductor comprising a connection portion 15 on one side and a surface mount connection terminal 16 on the other side. The surface mount connection terminal 16 may be for instance arranged in a row presenting contact pads intended for surface mount solder or welding connection, as *per se* known in the art, to circuit traces of an external circuit board. The surface mount connection terminals 16 are thus positioned proximate an outer edge of the transducer overmold housing 7, the IC connection side 15 being positioned proximate the IC chip 2 allowing bond wire connections between the IC chip 2 and the IC connection side 15 of the secondary conductors. In variants, the secondary conductor terminals may have stamped and formed contact portions with various shapes and configurations, for instance that project below and outwardly from the IC chip housing lower surface 18, adapted for surface mount connection to circuit board conductive traces as *per se* known in the art.

Bond wires 14 are connected between the IC connection side 15 of each secondary conductor 5 and connection terminals 11 on the active first side 9a of the IC chip 2. It may be noted that certain secondary conductors may have no connection to the IC chip, forming a redundant secondary conductor for use with semi-conductor chips with more connection portions. In other words, the number of connections depend on the functions incorporated in the IC chip. The lead frame conductor arrangement 3 may have a constant configuration, whereas the number of wire bond interconnections between the secondary conductors and IC chip may depend on the configuration of the IC chip and desired functionalities to be incorporated in the transducer.

An insulating layer 8 is positioned between the IC chip 2 and the primary conductor 4 of the lead frame arrangement 3. The insulating layer may for instance be a polyimide layer or another polymer layer typically of less than 0.2 mm thickness, preferably less than 0,1mm, for instance in a range from 0,05 to 0.1 mm.

The primary conductor 4 has first and second connection end terminals 10a, 10b that are in the form of surface mount connection pads configured for surface mount connection of the current transducer on an external circuit board. The first and second connection end terminals 10a, 10b are separated by a slot 6 having a width G.

A width **T1** of each of the first and second connection end terminal may advantageously be over 30%, preferably over 40% of a total width ***T*** of the current transducer in order to provide good electrical and especially thermal connection to the external circuit board on which the transducer is intended to be connected.

Typical widths ***T1*** of each connection end terminal 10a, 10b for applications of the present invention are in a range of 1mm to 5mm, typically in a range of 1mm to 4mm, for instance in a range of 1,5mm to 3mm.

Typical slot widths G for applications of the present invention are in a range of 0,2mm to 1mm, typically in a range of 0,3mm to 0,8mm, for instance in a range of 0,3mm to 0,6mm.

The primary conductor 4 has a bridging branch 13 interconnecting the first and second connection end terminals 10a, 10b. The bridging branch 13 forms a primary conductor measurement portion underlying the IC chip 2, and in particular underlying and overlapping the magnetic sensor of the IC chip 2. A current to be measured that flows between the first and second connection end terminals 10a, 10b, flows through the bridging branch and generates a magnetic field around the bridging branch that is correlated to the amplitude of the primary current to be measured. The bridging branch has a small cross-section compared to the primary conductor connection end terminals and thus concentrates the primary current and amplifies the associated generated magnetic field in the vicinity of the bridging branch.

According to the invention, the magnetic field sensor is configured as magnetic field gradient sensor having a first sensor 20a positioned overhead an inner edge 13a of the bridging branch 13 and a second sensor 20b positioned overhead an outer edge 13b of the bridging branch. The first and second sensors 20a, 20b should be spaced apart a certain minimal distance that allow a magnetic field gradient of sufficient intensity to be measured, which means that the bridging branch 13 should have a certain distance between the first and second edges 13a, 13b which defines the width ***W*** of the centre portion of the bridging branch 13. Preferably the width ***W*** of the centre portion of the bridging branch 13 is in a range of 0,4mm to 1,2mm, typically in a range of 0,4mm to 1mm, for instance in a range of 0,5mm to 0,8mm. The aforementioned dimensions may correspond to the spacing between the magnetic sensors 20, 20b, which may typically vary from 0.4 mm to 1mm.

The inner edge 8a of the bridging branch 13 extends across the slot 6 and preferably has a concave curved shape, and the outer edge 8b of the bridging branch preferably has a generally convex shape. The outer edge generally convex shape may be curved or comprise a flat section at a centre portion of the outer edge, overlapping with one of the magnetic field gradient sensors 20b.

In order to further concentrate the primary current, and thus increase the intensity of the generated magnetic field, while ensuring a desired minimum width of the bridging branch 13, the primary conductor 4 comprises an indent spanning across the bridging branch.

The sheet metal from which the lead frame is cut out and formed, has a thickness H1, which is thus also the thickness of the secondary conductors 5 and of the primary conductor connection terminals 10, 10b. The indent spanning across the bridging branch 13 has a thickness ***H2*** smaller than the thickness ***H1*** of the non-indent portion. The indent thickness ***H2*** is preferably less than 70% of the non-indent portion thickness ***H1*,** preferably less than 60%, for instance about 50% *(**H2<**0.7x**H1**,* preferably H2<0.6xH1, e.g ***H2*** = 0.5xH1).

Typical leadframe thickness ***H1*** for applications of the present invention are in a range of 0,2mm to 2mm, typically in a range of 0,3mm to 1mm, for instance in a range of 0,35mm to 0,6mm.

The indent may be formed by etching or other *per se* known subtractive manufacturing techniques (e.g. machining, grinding, spark erosion, ablative processes) or may be formed by stamping or rolling with a die that compresses and plastically deforms the material of the lead frame arrangement.

The indent advantageously reduces the primary conductor cross-section, while the position of the indent on the mounting side of the leadframe conductor arrangement ensures that the distance between the overhead magnetic field sensor 20 and the bridging branch 13 is as small as possible.

The width ***G*** of the slot 6 between the primary conductor connection terminals 10, 10b affects the length of the bridging branch 13, whereby the width should be no larger than necessary for measurement purposes, in order to minimize the length of the bridging branch and thus minimize resistance to the primary current flowing through the bridging branch.

The short primary conductor measurement portion formed by the bridging branch 13 thus locally induces the required differential magnetic field on the magnetic field sensor elements 20a, 20b while limiting the primary current resistance as much as possible.

The primary conductor 4 is partially embedded inside the overmold housing 7 keeping only the mounting side pads of the connection terminals 10a, 10b exposed. The measurement of the generated magnetic field is however sensitive to the way current enters into the pads due to local current density variations, resulting in local magnetic coupling variations. The local current density variations depends on the PCB conductor layout and thickness on the external circuit board on which the current transducer is mounted. This translates into a current transducer sensitivity which varies depending on the application PCB conductor layout, footprint and stackup (conductor thickness).

To reduce and limit magnetic coupling variations causing transducer sensitivity variations due to PCB layout and how current enters the pads, while still minimizing the overall primary conductor resistance, the indent of the bridging branch 13 comprises chamfer edges 17 formed in corners of the connection terminal pads 10a, 10b bounding the bridging branch. The chamfer edges 17 extend from the slot 19 and diverge outwardly from the slot at an average angle from a slot centreline ***C*** preferably in a range of 20 to 60°, preferably in a range of 20° to 50°, for instance in a range of 20° to 40°. The chamfer edge may be substantially straight, as illustrated, in which case the average angle is the angle of the straight line relative to the centreline. In variants, the chamfer edge may also diverge away from the centreline in a non straight manner, for instance have straight portions connected by bends, or may be curved, whereby an average angle can be defined as the cord angle of the chamfer formed from the start point at the slot edge to the end point on the connection terminal outer edge.

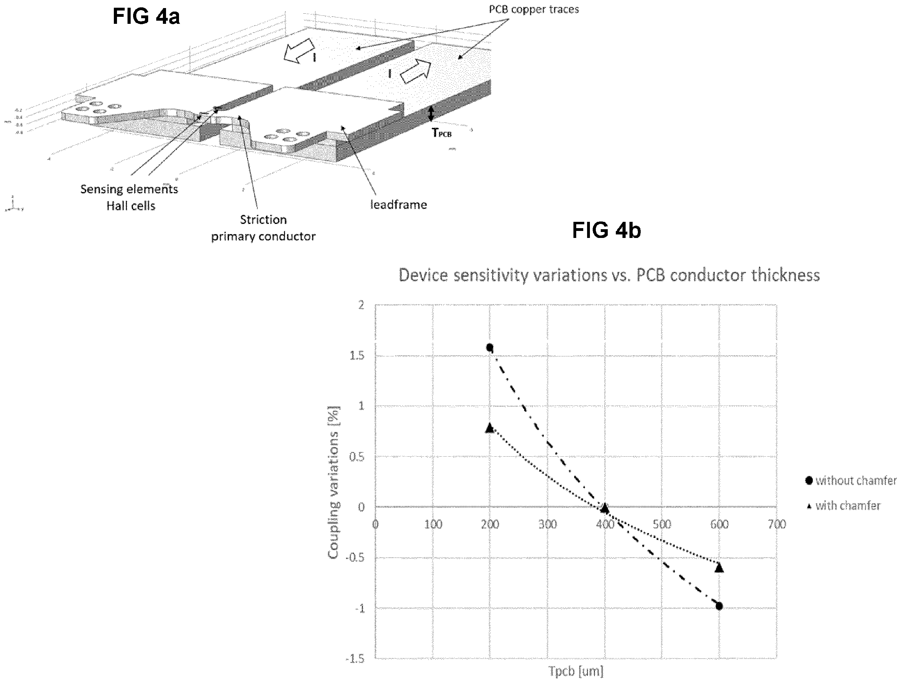

Figure 4b is a plot of a simulation of the variation of magnetic coupling between a PCB primary conductor trace and the primary conductor as illustrated in figure 4a, for an indent without chamfer and an indent with chamfer edges according to the invention, as a function of changing the thickness of the PCB conductor from 200um to 400um to 600um. It is shown that a variation of 200um thickness introduces more than 1.5% magnetic coupling variations (hence, sensitivity variation on the transducer) on the non-chamfer version, whereas it introduces less than 1% variation on a chamfer version according to the invention.

### List of references used

Current transducer 1
   **integrated circuit (IC) chip 2**
      **first side (active side) 9a**
         magnetic field sensor 20
            differential sensors 20a, 20b
         connection terminals 11
      **second side 9b**
   **insulating layer 8 (between IC chip and lead frame)**
   **lead frame arrangement 3**
      **secondary conductors 5**
         surface mount connection terminals 16
         secondary conductor bond wires 14
      **Primary conductor 4**
         Non-indent portion (connection terminals)
            Height H1
         Indent 13
            Height H2
            Indent inner edge 13a
            Indent outer edge 13b
            Indent chamfer edges 17
         Slot 6
      surface mount connection terminals 10a, 10b
   **Overmold housing 7**
      mounting side 18
*bridging branch centre portion width **W***
*leadframe thickness **H1***
*indent thickness **H2***
*slot width **G***
*chamfer to centreline angle **β***

## Claims

1. A current transducer (1) comprising a magnetic field sensor (20), a leadframe arrangement (3) comprising secondary conductors (5) and a primary conductor (4), and an overmold insulating housing encapsulating the magnetic field sensor and portions of the primary conductor and secondary conductors,
the primary conductor comprising a first connection end terminal (10a) and a second connection end terminal (10b) separate by a slot (6), and a bridging branch (13) interconnecting the first connection end terminal (10a) to the second connection end terminal, the first connection end terminal and a second connection end terminal having a thickness H1 and exposed pads for surface mount connection to conductive tracks on an external circuit board,
the bridging branch having an indent (13) with a thickness H2 smaller than the connection end terminal thickness H1, the indent spanning across the bridging branch, the bridging branch comprising chamfer edges (17) formed in corners of the first and second connection terminals bounding the bridging branch, the chamfer edges extending from the slot and diverging outwardly from the slot at an angle ***(β)*** from a centreline (C),
**characterised in that**
the magnetic field sensor comprises a first sensor (20a) and a second sensor (20b) spaced apart and configured for measuring a magnetic field gradient across a width of the bridging branch, and wherein the first sensor is positioned overhead an inner edge (13a) of the bridging branch and the second sensor is situated overhead an outer edge (13b) of the bridging branch.

2. The current transducer of claim 1 wherein an average value of said angle is in a range of 20 to 60°, preferably in a range of 20° to 50°, for instance in a range of 20° to 40°.

3. The current transducer of any preceding claim wherein the indent thickness ***H2*** is less than 70% of the connection terminal thickness ***H1** (**H2***<0.7x***H1**)* preferably less than 60% (***H2***<0.6x***H1),*** for instance about 50% (***H2*** = 0.5x***H1).***

4. The current transducer of any preceding claim wherein the first connection end terminal and a second connection end terminal thickness ***H1*** which corresponds to leadframe arrangement thickness, is in a range of 0,3mm to 1mm, for instance in a range of 0,35mm to 0,6mm.

5. The current transducer of any preceding claim wherein the indent extends into the leadframe arrangement from a mounting side including the exposed pads for surface mount connection.

6. The current transducer of any preceding claim comprising an integrated circuit (2), the magnetic field sensor being included in the integrated circuit.

7. The current transducer of any preceding claim wherein the magnetic field sensor is connected to the secondary conductors with bond wires.

8. The current transducer of any preceding claim wherein the magnetic field sensor is mounted on a surface of the primary conductor separated therefrom by an insulating layer (8).

9. The current transducer of any preceding claim wherein the primary conductor (4) comprises a shape that has mirror image symmetry about a centre line (***C***)*.*

10. The current transducer of any preceding claim wherein the first connection end terminal (10a) and second connection end terminal (10b) each have a width of over 30% of a total width of the current transducer, preferably of over 40%.

11. The current transducer of the preceding claim wherein the width ***T1*** of each connection end terminal is in a range of 1mm to 4mm, for instance in a range of 1,5mm to 3mm.

12. The current transducer of any preceding claim wherein a width ***G*** of the slot is in a range of 0,3mm to 0,8mm, for instance in a range of 0,3mm to 0,6mm.

## Patentansprüche

1. Stromwandler (1), der einen Magnetfeldsensor (20), eine Leiterrahmenanordnung (3), die Sekundärleiter (5) und einen Primärleiter (4) umfasst, und ein übergeformtes Isolationsgehäuse umfasst, das den Magnetfeldsensor und Abschnitte des Primärleiters und der Sekundärleiter einkapselt,
wobei der erste Primärleiter einen ersten Verbindungsendanschluss (10a) und einen zweiten Verbindungsendabschluss (10b), die durch einen Schlitz (6) getrennt sind, und einen Überbrückungszweig (13) umfasst, der den ersten Verbindungsendanschluss (10a) mit dem zweiten Verbindungsendanschluss verbindet, wobei der erste Verbindungsendanschluss und ein zweiter Verbindungsendanschluss eine Dicke H1 und freiliegende Pads zur oberflächenmontierten Verbindung mit leitfähigen Bahnen auf einer externen Leiterplatte aufweisen,
der Überbrückungszweig einen Einschnitt (13) mit einer Dicke H2 aufweist, die kleiner als eine Verbindungsendanschlussdicke H1 ist, wobei der Einschnitt sich über den Überbrückungszweig erstreckt,
der Überbrückungszweig abgeschrägte Ränder (17) umfasst, die in Ecken des ersten und des zweiten Verbindungsanschlusses gebildet sind, die den Überbrückungszweig begrenzen, wobei die abgeschrägten Ränder sich von dem Schlitz erstrecken und von dem Schlitz mit einem Winkel (β) von einer Mittellinie (C) nach außen auseinanderlaufen,
**dadurch gekennzeichnet, dass**
der Magnetfeldsensor einen ersten Sensor (20a) und einen zweiten Sensor (20b) umfasst, die voneinander beabstandet sind und zum Messen eines Magnetfeldgradienten durch eine Breite des Überbrückungszweigs ausgestaltet sind, und wobei der Sensor über einem inneren Rand (13a) des Überbrückungszweigs positioniert ist und der zweite Sensor sich über einem äußeren Rand (13b) des Überbrückungszweigs befindet.

2. Stromwandler nach Anspruch 1, wobei ein Durchschnittswert des Winkels in einem Bereich von 20 bis 60°, vorzugsweise in einem Bereich von 20° bis 50°, zum Beispiel in einem Bereich von 20° bis 40°, liegt.

3. Stromwandler nach einem der vorhergehenden Ansprüche, wobei die Einschnittdicke H2 kleiner als 70 % der Verbindungsanschlussdicke H1 (H2<0,7xH1), vorzugsweise kleiner als 60 % (H2<0,6xH1), zum Beispiel etwa 50 % (H2 = 0,5xH1), ist.

4. Stromwandler nach einem der vorhergehenden Ansprüche, wobei die erste Verbindungsendanschluss- und eine zweite Verbindungsendanschlussdicke H1, die der Leiterrahmenanordnungsdicke entspricht, in einem Bereich von 0,3 mm bis 1 mm, zum Beispiel in einem Bereich von 0,35 mm bis 0,6 mm, liegt.

5. Stromwandler nach einem der vorhergehenden Ansprüche, wobei der Einschnitt sich von einer Montageseite, welche die freiliegenden Pads zur oberflächenmontierten Verbindung umfasst, in die Leiterrahmenanordnung erstreckt.

6. Stromwandler nach einem der vorhergehenden Ansprüche, der eine integrierte Schaltung (2) umfasst, wobei der Magnetfeldsensor in der integrierten Schaltung enthalten ist.

7. Stromwandler nach einem der vorhergehenden Ansprüche, wobei der Magnetfeldsensor mit Bonddrähten mit den Sekundärleitern verbunden ist.

8. Stromwandler nach einem der vorhergehenden Ansprüche, wobei der Magnetfeldsensor auf einer Oberfläche des Primärleiters durch eine Isolationsschicht (8) davon getrennt montiert ist.

9. Stromwandler nach einem der vorhergehenden Ansprüche, wobei der Primärleiter (4) eine Form umfasst, die eine Spiegelsymmetrie um eine Mittellinie (C) aufweist.

10. Stromwandler nach einem der vorhergehenden Ansprüche, wobei der erste Verbindungsendanschluss (10a) und der zweite Verbindungsendanschluss (10b) jeweils eine Breite von über 30 %, vorzugsweise über 40 %, einer Gesamtbreite des Stromwandlers aufweisen.

11. Stromwandler nach dem vorhergehenden Anspruch, wobei die Breite T1 jedes Verbindungsendanschlusses in einem Bereich von 1 mm bis 4 mm, zum Beispiel in einem Bereich von 1,5 mm bis 3 mm, liegt.

12. Stromwandler nach einem der vorhergehenden Ansprüche, wobei eine Breite G des Schlitzes in einem Bereich von 0,3 mm bis 0,8 mm, zum Beispiel in einem Bereich von 0,3 mm bis 0,6 mm, liegt.

## Revendications

1. Transducteur de courant (1) comprenant un capteur de champ magnétique (20), un agencement de grille de connexion (3) comprenant des conducteurs secondaires (5) et un conducteur primaire (4), et un boîtier isolant surmoulé encapsulant le capteur de champ magnétique et des parties du conducteur primaire et des conducteurs secondaires,
le conducteur primaire comprenant une première borne d'extrémité de connexion (10a) et une deuxième borne d'extrémité de connexion (10b) séparées par une fente (6), et une branche de pontage (13) interconnectant la première borne d'extrémité de connexion (10a) à la deuxième borne d'extrémité de connexion, la première borne d'extrémité de connexion et une deuxième borne d'extrémité de connexion ayant une épaisseur H1 et des plots exposés pour une connexion à montage en surface avec des pistes conductrices sur une carte de circuit externe,
la branche de pontage ayant une indentation (13) dotée d'une épaisseur H2 plus petite que l'épaisseur de borne d'extrémité de connexion H1, l'indentation s'étendant de part et d'autre de la branche de pontage,
la branche de pontage comprenant des bords chanfreinés (17) formés dans des coins des première et deuxième bornes de connexion délimitant la branche de pontage, les bords chanfreinés s'étendant à partir de la fente et divergeant vers l'extérieur à partir de la fente selon un angle (β) par rapport à une ligne centrale (C),
**caractérisé en ce que**
le capteur de champ magnétique comprend un premier capteur (20a) et un deuxième capteur (20b) espacés et configurés pour la mesure d'un gradient de champ magnétique de part et d'autre d'une largeur de la branche de pontage, et dans lequel le premier capteur est positionné au-dessus d'un bord interne (13a) de la branche de pontage et le deuxième capteur est situé au-dessus d'un bord externe (13b) de la branche de pontage.

2. Transducteur de courant selon la revendication 1 dans lequel une valeur moyenne dudit angle est dans une plage de 20 à 60°, de préférence dans une plage de 20° à 50°, par exemple dans une plage de 20° à 40°.

3. Transducteur de courant selon une quelconque revendication précédente dans lequel l'épaisseur d'indentation H2 est inférieure à 70 % de l'épaisseur de borne de connexion H1 (H2 < 0,7 × H1) de préférence inférieure à 60 % (H2 < 0,6 × H1), par exemple d'environ 50 % (H2 = 0,5 × H1).

4. Transducteur de courant selon une quelconque revendication précédente dans lequel l'épaisseur H1 de la première borne d'extrémité de connexion et d'une deuxième borne d'extrémité de connexion qui correspond à une épaisseur d'agencement de grille de connexion, est dans une plage de 0,3 mm à 1 mm, par exemple dans une plage de 0,35 mm à 0,6 mm.

5. Transducteur de courant selon une quelconque revendication précédente dans lequel l'indentation s'étend dans l'agencement de grille de connexion à partir d'un côté de montage incluant les plots exposés pour une connexion à montage en surface.

6. Transducteur de courant selon une quelconque revendication précédente comprenant un circuit intégré (2), le capteur de champ magnétique étant inclus dans le circuit intégré.

7. Transducteur de courant selon une quelconque revendication précédente dans lequel le capteur de champ magnétique est connecté aux conducteurs secondaires avec des fils de câblage.

8. Transducteur de courant selon une quelconque revendication précédente dans lequel le capteur de champ magnétique est monté sur une surface du conducteur primaire séparée de celui-ci par une couche isolante (8).

9. Transducteur de courant selon une quelconque revendication précédente dans lequel le conducteur primaire (4) comprend une forme qui possède une symétrie d'image en miroir par rapport à une ligne centrale (C).

10. Transducteur de courant selon une quelconque revendication précédente dans lequel la première borne d'extrémité de connexion (10a) et la deuxième borne d'extrémité de connexion (10b) possèdent chacune une largeur de plus de 30 % d'une largeur totale du transducteur de courant, de préférence de plus de 40 %.

11. Transducteur de courant selon la revendication précédente dans lequel la largeur T1 de chaque borne d'extrémité de connexion est dans une plage de 1 mm à 4 mm, par exemple dans une plage de 1,5 mm à 3 mm.

12. Transducteur de courant selon une quelconque revendication précédente dans lequel une largeur G de la fente est dans une plage de 0,3 mm à 0,8 mm, par exemple dans une plage de 0,3 mm à 0,6 mm.
